Europäisches Patentamt

European Patent Office

Office européen des brevets

(19)

(11) **EP 0 690 898 B1**

(12) **EUROPÄISCHE PATENTSCHRIFT**

(45) Veröffentlichungstag und Bekanntmachung des Hinweises auf die Patenterteilung:
29.12.1997 Patentblatt 1997/52

(51) Int Cl.[6]: **C09K 3/00**, H03K 17/16, H03K 17/082

(21) Anmeldenummer: 93906438.2

(22) Anmeldetag: 24.03.1993

(86) Internationale Anmeldenummer:
PCT/DE93/00270

(87) Internationale Veröffentlichungsnummer:
WO 94/23497 (13.10.1994 Gazette 1994/23)

(54) **Schaltungsanordnung zum Schutz eines ein- und auschaltbaren Leistungshalbleiterschalters vor Überspannungen**

Circuit for protecting a power semiconductor switch that may be switched on and off against overvoltages

Circuit de protection contre les surtensions pour un commutateur semiconducteur de puissance pouvant être mis en circuit ou hors circuit

(84) Benannte Vertragsstaaten:
AT BE DE FR GB IT NL

(43) Veröffentlichungstag der Anmeldung:
10.01.1996 Patentblatt 1996/02

(73) Patentinhaber: SIEMENS AKTIENGESELLSCHAFT
80333 München (DE)

(72) Erfinder:
• MARQUARDT, Rainer
D-8522 Herzogenaurach (DE)
• SEIDL, Udo
D-8520 Erlangen (DE)

(56) Entgegenhaltungen:
EP-A- 0 311 576          EP-A- 0 499 921
DE-C- 4 037 348

• IEEE JOURNAL OF SOLID-STATE CIRCUITS. Bd. 25, Nr. 3 , Juni 1990 , NEW YORK US Seiten 677 - 682 SCHOOFS ET AL. 'A 700-V Interface IC for Power Bridge Circuits'
• U.TIETZE und Ch.SCHENK, "Halbleiterschaltungstechnik", 1983, Springer Verlag, Seite 73

**Beschreibung**

Die Erfindung bezieht sich auf eine Schaltungsanordnung zum Schutz eines über einen Steuereingang ein- und ausschaltbaren Leistungshalbleiterschalters vor energiereichen Überspannungen.

Bei Schaltvorgängen in Stromrichtern verursachen Induktivitaten im Leistungsteil von Stromrichtern Überspannungen, die je nach Hohe und Dauer zur Beschädigung der Leistungshalbleiter führen können. Vor allem die relativ schnell schaltenden Insulated-Gate-Bipolar-Transistor (IGBT)-Module selbst sind dabei gefährdet. Zum Schutz gegen solche Überspannungen ist es vorteilhaft, zunächst die parasitären Induktivitäten im Hauptstromkreis durch günstige Leitungsführung zu minimieren. Sodann werden verschiedenartige Beschaltungsnetze genutzt und auf kürzester Strecke verbunden. Diesen kommt außerdem die Aufgabe zu, den Betrieb im erlaubten Arbeitsbereich zu gewährleisten, sowie mitunter die Abschaltverlustleistung herabzusetzen. RCD-Einzelbeschaltung wird seit vielen Jahren zum Schutz von Leistungshalbleitern genutzt, und eignet sich auch zum Beispiel für IGBT-Module. Die Anordnung besteht aus einem Kondensator, der in Reihe zu einer Diode mit parallelem, Widerstand liegt. Wenn zum Beispiel bei höherer Pulsfrequenz die am Widerstand in Wärme umgesetzte Verlustleistung beachtliche Werte annimmt, ist dies aber grundsätzlich unerwünscht. Häufiger werden kostengünstigere Maßnahmen angewendet (vgl. etz, Band 110 (1989), Seiten 464-471), wie RCD-Spannungsbegrenzer für Zweigpaare (Bild 6b) oder die Summenbeschaltung auf der Gleichstromseite (Bild 6d), die außerdem weniger Verlustleistung verursachen. Dafür sind diese allerdings auch nicht ganz so wirkungsvoll. RCD-Spannungsbegrenzungsschaltungen werden häufig auch als Spannungsklemmbeschaltung bezeichnet.

Der Zweck von Spannungsklemmbeschaltungen ist die Begrenzung der Überspannung, die beim Schalten von Leistungshalbleiterschaltern - in der Folge kurz mit LHL bezeichnet - aufgrund von zumeist aufbaubedingten Induktivitäten entstehen, auf einen für den LHL sicheren Wert.

Verwendet man zur Spannungsbegrenzung nur das bekannte (RCD)-Beschaltungnetzwerk als "Spannungsklemmbeschaltung", so ist die auf den größtmöglichen Abschaltstrom zu dimensionieren. Will man aber auch die Fähigkeit moderner LHL, die sogar die Abschaltung von Kurzschlußströmen, die mehr als das Zehnfache des periodisch erlaubten Stroms erreichen können, ausnutzen, so ist der Beschaltungs-Kondensator entsprechend groß für den Kurzschlußfall zu dimensionieren. Hierbei muß berücksichtigt werden, daß die in der Aufbauinduktivität gespeicherte Energie mit dem Quadrat des Abschaltstroms anwächst. Eine große Beschaltung bedeutet nicht nur einen höheren Bauteileaufwand und damit höhere Kosten, sondern es erhöhen sich außerdem auch in der RCD-Beschaltung entstehenden Verluste. Bei hohen Schaltfrequenzen ($f_S \approx 10$ kHz) sind relativ große Verlustleistungen über den Beschaltungs-Widerstand abzuführen. Dadurch kompliziert sich nicht nur die Aufbautechnik, es erhöht sich auch der Kühlungsaufwand; außerdem sinkt der Wirkungsgrad der Schaltung nicht unerheblich.

Verwendet man eine Spannungsklemmbeschaltung mittels Zener-Diode zwischen einem Hauptanschluß (Kollektor, Drain) und dem Steueranschluß (Gate, Basis) eines Power-MOSFETs (Bull. ASE/UCS 77 (1986) 16, 23. August, Seiten B388-B391)), so wird die Zener-Spannung der Zener-Diode auf die maximal in der Schaltung zugelassene Spitzenspannung dimensioniert.

Ist die von der Aufbauinduktivität verursachte Spannungsspitze größer als die Zener-Spannung, so kann ein (kleiner) Strom über die Zener-Diode zum Steueranschluß des Leistungshalbleiterschalters (z.B. Power-MOSFET, IGBT) fließen und diesen leitend steuern. Dies geschieht in idealer Weise aber nur bis zu einem gewissen Grad, so daß der Leistungshalbleiterschalter gerade so weit angesteuert wird, daß die Spannung an einem Hauptpfad (C-E oder D-S oder C-S, je nach Bauelementtyp) so lange immer genau der Zener-Spannung entspricht, bis der Stromfluß im Hauptpfad beendet ist und die Aufbauinduktivität die gespeicherte Energie vollständig an den Halbleiterschalter abgegeben hat. Eine Spannungsklemmbeschaltung mittels Zener-Diode zwischen einem Hauptanschluß und dem Steueranschluß eines Leistungshalbleiterschalters weist folgende Nachteile auf:

- Die Spannungsbegrenzung ist durch die Herstellungstoleranzen und den Temperaturkoeffizienten der Zener-Dioden sehr ungenau (ca. ± 5% Herstellung plus ca. 10% zusätzlicher Fehler bei 100 K Temperaturhub),
- die Verlustleistung der Zener-Diode ist so groß, daß die Funktion dieser Spannungsbegrenzung im allgemeinen nur für seltene Störungsfälle und nicht bei der vorgesehenen Schaltfrequenz im gepulsten Dauerbetrieb benutzt werden kann, und deshalb
- zusätzliche Beschaltungen der Leistungstransistoren notwendig sind, um im Betrieb die Spannungen zu begrenzen, die bekanntlich einen großen und unerwünschte Verlustleistung in den Beschaltungswiderständen verursachen (verlust freie Beschaltungsnetzwerke erfordern noch höheren Aufwand).

Aus der Veröffentlichung "A 700-V Interface IC for Power Bridge Circuits", abgedruckt in "IEEE Journal of Solid-State Circuits", Band 25, Nr. 3, Juni 1990, Seiten 677-682, ist eine Schutzeinrichtung für einen ein- und ausschaltbaren Leistungs-MOS-Transistor bekannt, die einen analogen Differenzverstärker aufweist. An den Eingängen dieses Differenzverstärkers stehen eine Soll-Spannung und eine Drain-Source-Spannung (Ist-Spannung) an. Der Ausgang dieses Differenzverstärkers ist über ein Latch mit dem Steuereingang des zu überwachenden Leistungs-MOS-Transistors verbunden.

Diese Schutzschaltung überwacht den Leistungs-MOS-Transistor. Die gemessene Drain-Source Spannung wird zum Schutz des Leistungs-MOS-Transistors vor Überlastung verwendet.

Aus der EP 0 311 576 A2 ist eine Überspannungsschutzschaltung für einen Transistor, der eine induktive Last schaltet, bekannt. Diese Schutzschaltung weist einen Spannungsteiler, einen analogen Differenzverstärker und eine Schaltungsanordnung zur Generierung einer Referenzspannung auf. Mittels des Spannungsteilers wird die Kollektorspannung des Transistors dem Differenzverstärker zugeführt, der diesen Spannungswert mit dem Referenzwert vergleicht. Sobald die Kollektorspannung den Referenzwert übersteigt, wechselt der Differenzverstärker, der hier als Komparator arbeitet, sein Ausgangspegel, so daß der zu überwachende Transistor wieder eingeschaltet wird. Da die Referenzspannung mittels einer Schaltungsanordnung aus der Versorgungsspannung generiert wird, ist diese Schutzschaltung von der Temperatur und von Spannungsschwankungen der Versorgungsspannung unabhängig.

Der Erfindung liegt nun die Aufgabe zugrunde, eine Schaltungsanordnung zum Schutz eines über einen Steuereingang ein-und abschaltbaren Leistungshalbleiterschalters vor energiereichen Überspannungen anzugeben, wobei die obengenannten Nachteile vermieden werden sollen.

Diese Aufgabe wird erfindungsgemäß dadurch gelöst, daß die Schaltungsanordnung bestehend aus einem analogen Differenzverstärker, der eine Konstantstromquelle und einen ersten und einen zweiten Transistor mit Emitterwiderständen zur Stromgegenkopplung aufweist, einem Spannungsteiler und einer Referenzspannungsquelle, wobei der Spannungsteiler eingangsseitig zwischen einem Haupt- und Emitteranschluß des Leistungshalbleiterschalters und ausgangsseitig mit einem Eingang des analogen Differenzverstärkers verbunden ist, dessen anderer Eingang mittels der Referenzspannungsquelle und dessen einer Ausgang am Kollektoranschluß des ersten Transistors mit dem Emitteranschluß des Leistungshalbleiterschalters verbunden sind, wobei dessen anderer Ausgang am Kollektoranschluß des zweiten Transistors mit einem Eingang einer Ansteuerschaltung des Leistungshalbleiterschalters verknüpft ist.

Durch die Ausgestaltung dieser Schaltungsanordnung kann auf ein RCD-Beschaltungsnetzwerk für einen Leistungshalbleiterschalter verzichtet werden, da kleinste Spannungsabweichungen am Hauptanschluß eines Leistungshalbleiterschalters sofort erkannt werden, und der Leistungshalbleiterschalter gesteuert ausgeschaltet wird. Durch Wegfallen des RCD-Beschaltungsnetzwerkes entfallen auch deren Nachteile. Somit erhält man eine Schaltung zum Schutz gegen Überspannungen mit verringerten Beschaltungsverlusten bei Vermeidung des Beschaltungsaufwandes.

Bei einer weiteren vorteilhaften Ausführungsform ist ein Widerstand des Spannungsteilers, der mit dem Hauptanschluß eines Leistungshalbleiterschalters verbunden ist, in mehrere elektrisch in Reihe geschaltete Widerstände unterteilt. Durch diese Ausführungsform des Spannungsteilers ist die Meßbereichsanpassung und ein guter Frequenzgang realisierbar.

Bei einer besonders vorteilhaften Ausführungsform der Schaltungsanordnung ist der eine Eingang des analogen Differenzverstärkers mittels einer Entkopplungsdiode mit einem Steuereingang verbunden, an dem ein Steuersignal ansteht. Dadurch kann man den analogen Differenzverstärker außerdem für die Verstärkung des Steuersignals nutzen, wobei das Steuersignal einem Eingang des Differenzverstärkers zugeführt wird, an dem die Ist-Spannung des Hauptanschlusses eines Leistungshalbleiterschalters ansteht. Durch diese Ausführungsform kann man bei der Bemessung der Ansteuereinrichtung den Leistungsverstärkungsfaktor der Schaltungsanordnung miteinbeziehen, wodurch der notwendige Verstärkungsfaktor der Endstufen einer bekannten Ansteuereinrichtung sich verringert.

Zur weiteren Erläuterung der Erfindung wird auf die Zeichnung Bezug genommen, in der eine Ausführungsform der erfindungsgemäßen Schaltungsanordnung zum Schutz von Leistungshalbleiterschaltern vor Überspannungen schematisch veranschaulicht sind.

Figur 1    zeigt ein Zweigpaar eines bekannten Stromrichters, in

Figur 2    ist ein Zweigpaar eines Stromrichters dargestellt, dessen Leistungshalbleiterschalter jeweils mit einem Blockschaltbild einer erfindungsgemäßen Schaltungsanordnung versehen sind, und die

Figur 3    veranschaulicht eine Realisierung der erfindungsgemäßen Schaltungsanordnung, die Bestandteil einer bekannten Ansteuereinrichtung ist.

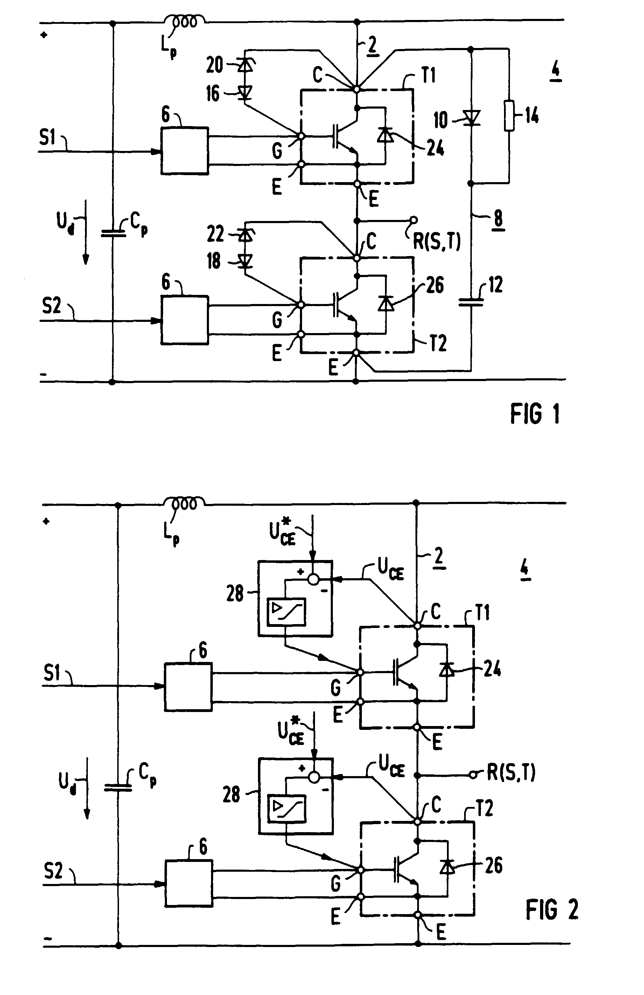

In Figur 1 ist ein Zweigpaar 2 eines Stromrichter 4 dargestellt, das zwei ein- und ausschaltbaren Leistungshalbleiterschaltern T1 und T2 besteht. Als Leistungshalbleiterschalter T1 bzw. T2 können Power-MOSFETs und Insulated-Gate-Bipolar-Transistoren (IGBT) verwendet werden. Diese Leistungshalbleiterschalter T1 und T2 werden über ihre jeweiligen Gate-Emitter-Anschlüsse mittels einer Ansteuereinrichtung 6 in Abhängigkeit eines Steuersignals S1 und S2 angesteuert. Am Ausgang jeden Zweigpaares ist als eine gemeinsame Spitzenspannungsbegrenzung (Sammelklemmbeschaltung) ein RCD-Glied 8, bestehend aus einer Diode 10, einem Kondensator 12 und einem Widerstand 14, angeordnet. Die Gate-Kollektor-Strecke jedes LHL-Moduls T1 bzw. T2 wird durch eine Diode 16 bzw. 18 und eine Beschaltung-Zenerdiode 20 bzw. 22 überbrückt. Jeweils eine weitere Diode 24 bzw. 26 ist dem LHL-Modul T1 bzw. T2 gegenparallel in Richtung der Emitter-Kollektor-Strecke des LHL-Moduls T1 bzw. T2 geschaltet und dient als Rücklaufdiode in Wechselrichterschaltungen mit Spannungszwischenkreis. Diese Freilaufdioden 24, 26 können auch im Modul T1, T2 integriert sein und werden dann Reversdioden genannt.

Beim Abschalten eines LHL-Moduls T1 oder T2 wird die in der Aufbauinduktivität $L_p$ gespeicherte Energie auf den Klemmbeschaltungskreis aus Diode 10 und Kondensator 12 abgegeben. Die Spannung am Beschaltungkondensator 12 entspricht dabei anfangs dem Wert der Zwischenkreisspannung $U_d$. Aufgrund der Energieabgabe der Aufbauinduktivität $L_p$ erhöht sich die Spannung am Beschaltungskondensator 12 auf einen bei idealen Verhältnissen theoretisch vorausbestimmbaren Höchstwert. Nach Energieabgabe der Aufbauinduktivität $L_p$ gibt der Beschaltungkondensator 12 den aufgenommenen Energiebetrag über den Beschaltungs-Widerstand 14 an den Zwischenkreiskondensator $C_p$, so daß nach einigen Zeitkonstanten der Ausgangszustand $U_{12} = U_d$ wiederhergestellt ist.

Die Beschaltungs-Zenerdiode 20 bzw. 22 ist so gemessen, daß im störungsfreien Schaltbetrieb die an einem Schaltungkondensator 12 entstehende Spitzenspannung kleiner ist als die Zener-Spannung, jedoch bei Überstrom die Zener-Spannung erreicht wird. Wird nämlich unter dem Einfluß der Energieabgabe der Aufbauinduktivität $L_p$ die Spannung am Beschaltungskondensator 12 größer als die Zener-Spannung, wird das LHL-Modul T1 bzw. T2 über die Zenerdiode 20 bzw. 22 leitend gesteuert und kann somit die weitere Energie der Aufbauinduktivität $L_p$ übernehmen, die dabei in der Hauptstrecke des LHL-Moduls T1 bzw. T2 in Wärme umgesetzt wird.

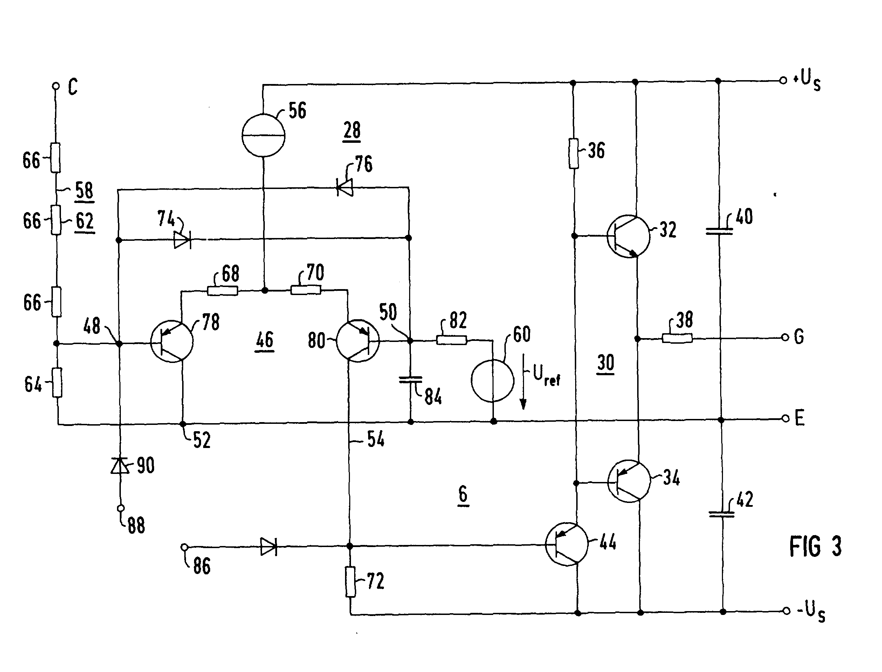

In der Figur 2 ist ein Zweigpaar 2 eines Stromrichters 4 nach Figur 1 dargestellt, wobei jedoch auf ein RCD-Glied 8 und auf die Dioden 16, 18 und die Zenerdioden 20, 22 verzichtet wurden. Dafür ist jedes LHL-Modul T1, T2 mit einer erfindungsgemäßen Schaltungsanordnung 28 zum Schutz der abschaltbaren Leistungshalbleiterschalter T1, T2 vor Schalt-Überspannungen versehen. Diese Schaltunganordnung 28 besteht aus einem Analogverstärker mit Begrenzungskennlinie. Am Verstärker steht einerseits eine Ist-Spannung $U_{CE}$ und eine Soll-Spannung $U^*_{CE}$ des Hauptanschlusses C des Leistungshalbleiterschalters T1 bzw. T2 an. Der Analogverstärker ist ausgangsseitig mit dem Steuereingang G des LHL-Moduls T1 bzw. T2 elektrisch leitend verbunden. Anhand einer realisierten Schaltung gemäß Figur 3 wird der nähere Aufbau der Schaltungsanordnung 28 und deren Funktion näher beschrieben.

In der Figur 3 sind die Ansteuereinrichtung 6 und die Schaltungsanordnung 28 zum Schutz gegen Schalt-Überspannungen als eine gemeinsame Baueinheit dargestellt. Die Ansteuereinrichtung 6 besteht aus einer Gegentaktstufe 30, bestehend aus zwei Transistoren 32 und 34 und zwei Widerständen 36 und 38, zwei Kondensatoren 40 und 42 und einem Signalverstärker 44.

Am Eingang dieses Signalverstärkers 44 steht ein Steuersignal S1 bzw. S2 an, das mittels dieses Signalverstärkers 44 und der Gegentaktstufe 30, auch Treiberstufe genannt, dem Steuereingang G eines LHL-Moduls T1 bzw. T2 zugeführt wird, wobei das Steuersignal S1 bzw. S2 zu einem vom LHL-Modul T1 bzw. T2 benötigten Steuerstrom umgewandelt wird. Der Widerstand 38, auch Steuerkreiswiderstand genannt, begrenzt die Höhe der beim Ein- und Ausschalten auftretenden Steuerstromimpulse. Die Kondensatoren 40 und 42 sind elektrisch in Reihe geschaltet, wobei der Verbindungspunkt mit einem Emitter- bzw. Kollektoranschluß E eines LHL-Moduls T1 bzw. T2 verbunden ist (Bezugspotential der Schaltungsanordnung 28), wobei am freien Anschluß des Kondensators 40 eine positive Speisespannung $+U_S$ und am freien Anschluß des Kondensators 42 eine negative Speisespannung $-U_S$ angeschlossen sind. Die Spannungen der Speisespannungen $+U_S$ und $-U_S$ richten sich nach den erforderlichen Gate-Spannungen der zu steuernden LHL-Moduln T1 bzw. T2 und betragen typischerweise +15V und -15V. Diese bekannte Ansteuereinrichtung 6 bzw. weitere Ausführungsformen sind dem Artikel "IGBT-Module in Stromrichtern: regeln, steuern, schützen", von W. Bösterling, R. Jörke und M. Tscharn, abgedruckt in "etz", Band 110 (1989), Heft 10, Seiten 464-471, insbesondere dem Abschnitt "Treiberstufen für Ein- und Ausschalten", zu entnehmen.

Die Schaltungsanordnung 28 zum Schutz vor Überspannungen wird erfindungsgemäß durch einen analogen Differenzverstärker 46 gebildet. Gemäß dem Lehrbuch "Halbleiter-Schaltungstechnik", von U. Tietze und Ch. Schenk, 1983, Seiten 66-76, ist der Differenzverstärker 46 ein symmetrischer Gleichspannungsverstärker mit zwei Eingängen 48 und 50 und zwei Ausgängen 52 und 54, wobei der eine Ausgang 52 mit dem Bezugspotential der Schaltungsanordnung 28 und der andere Ausgang 54 mit dem Eingang des Signalverstärkers 44 der Ansteuereinrichtung 6 elektrisch leitend verbunden sind. Kennzeichnend für den Differenzverstärker 46 ist u.a. die Konstantstromquelle 56, die eingangsseitig mit der positiven Speisespannung $+U_S$ verbunden ist. Der Eingang 48 des Differenzverstärkers 46 ist mit einem Ausgang eines Spannungsteilers 58 verbunden und am Eingang 50 ist eine Referenzspannungsquelle 60 angeschlossen, die außerdem mit dem Emitter- bzw. Kollektoranschluß E (Bezugspotential) eines LHL-Moduls T1 bzw. T2 verbunden ist. Mittels des Spannungsteilers 58, der einerseits mit dem Hauptanschluß C und andererseits mit dem Emitteranschluß E eines LHL-Moduls T1 bzw. T2 elektrisch leitend verbunden ist, wird die Ist-Spannung $U_{CE}$ des LHL-Moduls T1 bzw. T2 erfaßt.

Dieser Spannungsteiler 58, der aus einem ersten und einem zweiten Widerstand 62 und 64 besteht, dient zur Meßbereichsanpassung. Durch eine geeignete Wahl der Widerstandswerte und eine bedarfsweise Aufteilung des Widerstands 62 auf mehrere elektrisch in Reihe geschaltete Teilwiderstände 66, ist die Meßbereichsanpassung und ein guter Frequenzgang realisierbar. Die Widerstände 68, 70 und 72 ermöglichen es, die Verstärkung des Differenzverstärkers 46 im linearen Teil der Kennlinie anzupassen. Die Dioden 74 und 76 erlauben es, eine Übersteuerung der Transistoren 78 und 80 des analogen Differenzverstärkers 46 zu vermeiden, die zu Zeitverzögerungen führen würden. Die Referenzspannung $U_{ref}$ der Referenzspannungsquelle 60 bestimmt die Soll-Spannung $U^*_{CE}$ des LHL-Moduls T1 bzw. T2 gemäß folgender Gleichung

$$U^*_{CE} = (1 + \frac{R1}{R2}) \cdot U_{ref} ,$$

wobei mit R1 der Widerstand 62 und mit R2 der Widerstand 64 des Spannungsteilers 58 gemeint sind. Der Widerstand 82 dient zur Kompensation des Spannungsabfalls durch den Basisstrom der Transistoren 78 und 80, der sonst zur Abweichung der Soll-Spannung $U^*_{CE}$ führen würde. Der Kondensator 84 am Eingang 50 des Differenzverstärkers 46 ist zur hochfrequenzmäßigen Erdung der Basis vom Transistor 80 vorgesehen.

Das Steuersignal S1 bzw. S2 kann an verschiedenen Punkten der Ansteuereinrichtung 6 mit integrierter Schaltungsanordnung 28 zum Schutz vor Überspannungen zugeführt werden. Wird das Steuersignal S1 bzw. S2 am Steuereingang 86 der Ansteuereinrichtung 6 angelegt, so wird dieses Steuersignal S1 bzw. S2 wie gehabt nur von der Ansteuereinrichtung 6 in einen Steuerstromimpuls gewandelt. Wird dagegen das Steuersignal S1 bzw. S2 am Steuereingang 88, der mittels einer Entkopplungsdiode 90 mit dem einen Eingang 48 des analogen Differenzverstärkers 46 verknüpft ist, gelegt, so wird die Verstärkung des analogen Differenzverstärkers 46 zusätzlich zur Verstärkung der Treiberstufe 30 der Ansteuereinrichtung 6 benutzt. Aus diesem Grunde kann man die Verstärkung der Treiberstufe 6 verringern, wodurch sich auch die Verlustleistung verringert.

Durch die Verwendung der erfindungsgemäßen Schaltungsanordnung 28 zum Schutz gegen Überspannungen werden keine zusätzlichen Beschaltungsnetzwerke für die LHL-Module T1 und T2 bzw. für das Zweigpaar 2 des Stromrichters 4 mehr benötigt, so daß sich der Aufwand sehr verringert und die räumlichen Abmessungen eines Stromrichters 4 sich verkleinern. Wird die Schaltungsanordnung 28 außerdem noch in die Ansteuereinrichtung 6 eines jeden LHL-Moduls T1, T2 integriert und der eine Eingang 48 des Differenzverstärkers 46 als Steuereingang mitbenutzt, so kann durch die Aufteilung der Gesamtverstärkung auf die Treiberstufe 30 und auf den analogen Differenzverstärker 46 die Verlustleistung verringert werden.

**Patentansprüche**

1. Schaltungsanordnung (28) zum Schutz eines über einen Steuereingang (G) ein- und ausschaltbaren Leistungshalbleiterschalters (T1,T2) vor energiereichen Überspannungen, bestehend aus einem analogen Differenzverstärker (46), der eine Konstantstromquelle (56) und einen ersten (78) und einen zweiten (80) Transistor mit Emitterwiderständen (68,70) zur Stromgegenkopplung aufweist, einem Spannungsteiler (58) und einer Referenzspannungsquelle (60), wobei der Spannungsteiler (58) eingangsseitig zwischen einem Haupt- und Emitteranschluß (C,E) des Leistungshalbleiterschalters (T1,T2) und ausgangsseitig mit einem Eingang (48) des analogen Differenzverstärkers (46) verbunden ist, dessen anderer Eingang (50) mittels der Referenzspannungsquelle (60) und dessen einer Ausgang (52) am Kollektoranschluß des ersten Transistors (78) mit dem Emitteranschluß (E) des Leistungshalbleiterschalters (T1) verbunden sind, wobei dessen anderer Ausgang (54) am Kollektoranschluß des zweiten Transistors (80) mit einem Eingang einer Ansteuereinrichtung (6) des Leistungshalbleiterschalters (T1,T2) verknüpft ist.

2. Schaltungsanordnung (28) nach Anspruch 1, **dadurch gekennzeichnet,** daß die Eingänge (48,50) des analogen Differenzverstärkers (46) jeweils mittels einer Diode (74,76) miteinander elektrisch leitend verbunden sind.

3. Schaltungsanordnung (28) nach Anspruch 1, **dadurch gekennzeichnet,** daß ein Widerstand (62) des Spannungsteilers (58), der mit dem Hauptanschluß (C) des Leistungshalbleiterschalters (T1,T2) verbunden ist, in mehrere elektrisch in Reihe geschalteter Teilwiderstände (66) unterteilt ist.

4. Schaltungsanordnung (28) nach Anspruch 1, **dadurch gekennzeichnet,** daß der andere Eingang (50) des analogen Differenzverstärkers (46) mittels eines Kondensators (84) mit dem Emitteranschluß (E) des Leistungshalbleiterschalters (T1,T2) elektrisch leitend verbunden ist.

5. Schaltungsanordnung (28) nach Anspruch 1, **dadurch gekennzeichnet,** daß der eine Eingang (48) des analogen Differenzverstärkers (46) mittels einer Entkopplungsdiode (90) mit einem Steuereingang (88) verbunden ist, an dem ein Steuersignal (S1,S2) ansteht.

**Claims**

1. Circuit arrangement (28) for protecting a power semiconductor switch (T1, T2), which can be switched on and off by way of a control input (G), against high-energy overvoltages, comprising an analog difference amplifier (46), which has a constant-current source (56) and a first transistor (78) and a second transistor (80) having emitter resistors (68,70) for negative current feedback, a voltage divider (58) and a reference voltage source (60), with the input side of the voltage divider (58) being connected between a main terminal (C) and an emitter terminal (E) of the power semiconductor switch (T1, T2) and the output side of said voltage divider being connected to an input (48) of the analog difference amplifier (46), the other input (50) of which, by means of the reference voltage source (60), and the one output (52) of which, at the collector terminal of the first transistor (78), are connected to the emitter terminal (E) of the power semiconductor switch (T1), with the other output (54) of said analog difference amplifier, at the collector terminal of the second transistor (80), being connected to an input of a trigger device (6) of the power semiconductor switch (T1, T2).

2. Circuit arrangement (28) according to claim 1, characterised in that the inputs (48, 50) of the analog difference amplifier (46) are in each case connected to each other in an electrically conductive manner by means of a diode (74, 76).

3. Circuit arrangement (28) according to claim 1, characterised in that a resistor (62) of the voltage divider (58), which is connected to the main terminal (C) of the power semiconductor switch (T1, T2), is divided into a plurality of component resistors (66), which are electrically connected in series.

4. Circuit arrangement (28) according to claim 1, characterised in that the other input (50) of the analog difference amplifier (46) is connected in an electrically conductive manner to the emitter terminal (E) of the power semiconductor switch (T1, T2) by means of a capacitor (84).

5. Circuit arrangement (28) according to claim 1, characterised in that the one input (48) of the analog difference amplifier (46) is connected to a control input (88), at which a control signal (S1, S2) is present, by means of a decoupling diode (90).

**Revendications**

1. Montage (28) de protection d'un interrupteur (T1,T2) d'un semiconducteur de puissance, pouvant être branché et débranché par l'intermédiaire d'une entrée (G) de commande, vis-à-vis de surtensions riches en énergie, constitué d'un amplificateur différentiel analogique (46), qui comporte une source (56) de courant constant, un premier (78) et un second (80) transistor à résistance (68,70) d'émetteur pour la contre-réaction de courant, d'un diviseur (58) de tension et de source (60) de tension de référence, le diviseur (58) de tension étant relié en entrée entre une borne principale (C) et une borne d'émetteur (E) de l'interrupteur (T1,T2) à semiconducteur de puissance et étant relié en sortie à une entrée (48) de l'amplificateur (46) différentiel analogique, dont l'autre entrée (50) est reliée au moyen de la source (60) de tension de référence à la borne (E) d'émetteur de l'interrupteur (T1) à semiconducteur de puissance et dont une sortie (52) à la borne de collecteur du premier transistor (78) est reliée à la borne (E) d'émetteur de l'interrupteur (T1) à semiconducteur de puissance, son autre sortie (54) à la borne de collecteur du second transistor (80) étant combinée avec une entrée d'un dispositif (6) de commande de l'interrupteur (T1,T2) à semiconducteur de puissance.

2. Montage (28) suivant la revendication 1, caractérisé en ce que , les entrées (48,50) de l'amplificateur (46) différentiel analogique sont reliées entre elles de manière à conduire l'électricité au moyen d'une diode (74,76).

3. Montage (28) suivant la revendication 1, caractérisé en ce que, une résistance (62) du diviseur (58) de tension, qui est reliée à la borne (C) principale de l'interrupteur (T1,T2) à semiconducteur de puissance est subdivisée en plusieurs résistances partielles (66) montées électriquement en série.

4. Montage (28) suivant la revendication 1, caractérisé en ce que l'autre entrée (50) de l'amplificateur différentiel analogique (46) est reliée de manière à conduire l'électricité au moyen d'un condensateur (84) à la borne d'émetteur (E) de l'interrupteur (T1, T2) du semiconducteur de puissance.

5. Montage (28) suivant la revendication 1, caractérisé en ce que, l'une des entrées (48) de l'amplificateur (46) différentiel analogique est reliée au moyen d'une diode (90) de découplage à une entrée (88) de commande, à laquelle est appliqué un signal (S1,S2) de commande.

FIG 1

FIG 2

7

FIG 3